# FASCICULE DE BREVET EUROPEEN

(11) **EP 1 950 611 B1**
(45) Date de publication et mention de la délivrance du brevet: **31.08.2011**
(21) Numéro de dépôt: 08354001.3
(22) Date de dépôt: 16.01.2008
(51) Int. Cl.: G03F 7/16

(54) **Procédé de dépôt d'une couche polymère sur une face d'un support, comportant au moins une zone en creux**
Verfahren zur Aufbringung einer Polymerschicht auf eine Fläche einer Unterlage, die mindestens eine vertiefte Zone umfasst
Method for depositing a polymer layer on a support surface comprising at least one hollow area

(30) Priorité: 23.01.2007 FR 0700450
(43) Date de publication de la demande: 30.07.2008
(73) Titulaire: Commissariat à l'Énergie Atomique et aux Énergies Alternatives, 75015 Paris (FR)
(72) Inventeur: Puget, Christiane, 38120 Saint-Egrève (FR); Henry, David, 38610 Gières (FR)
(74) Mandataire: Hecké, Gérard

(56) Documents cités:
- JP-A- 2005 019 560
- US-A- 5 260 174
- US-A- 5 849 435
- FISCHER K ET AL: "Spray coating - a solution for resist film deposition across severe topography" ELECTRONICS MANUFACTURING TECHNOLOGY SYMPOSIUM, 2004. IEEE/CPMT/SEMI 29TH INTERNATIONAL SAN JOSE, CA, USA JULY 14-16, 2004, PISCATAWAY, NJ, USA,IEEE, 14 juillet 2004 (2004-07-14), pages 338-342, XP010715512 ISBN: 0-7803-8583-7

## Description

### Domaine technique de l'invention

L'invention concerne un procédé de dépôt d'une couche à base de polymère sur une face d'un support, ladite face comportant une partie principale plane et au moins une zone en creux par rapport à la partie principale plane.

### État de la technique

La réalisation de dispositifs électroniques, tels que des composants microélectroniques ou des microsystèmes, nécessite le plus souvent la réalisation d'une étape de lithographie destinée à transférer des motifs sur un substrat. L'étape de lithographie consiste, de manière générale, à déposer une couche en résine photosensible sur un substrat. La couche en résine photosensible est, ensuite insolée, à travers un masque structuré, c'est-à-dire à travers un masque comportant des motifs. La résine photosensible est, enfin, développée de manière à obtenir, dans ladite résine, des motifs correspondant soit aux motifs du masque (cas d'une résine photosensible positive), soit aux parties complémentaires des motifs du masque (cas d'une résine photosensible négative). Une étape de gravure peut ensuite être réalisée à travers la résine photosensible structurée pour transférer les motifs dans le substrat.

L'étape de lithographie et en particulier la phase correspondant au dépôt de la couche en résine photosensible, également appelée phase de couchage de la résine, sont critiques en terme de résolution et de qualité.

La technique la plus classiquement utilisée pour déposer la couche en résine sur un substrat, est le dépôt de résine par centrifugation, également connu sous le nom anglo-saxon de « spin coating ». Cette technique consiste à former un film mince uniforme sur un substrat, par mise en rotation dudit substrat. Un liquide est, ainsi, déposé sur la surface du substrat. Il est, ensuite, étalé sous forme d'une couche, par action d'une force centrifuge créée par la mise en rotation du substrat. Ceci forme, une fois le solvant évaporé, un film mince en résine photosensible. Bien que largement répandue, cette technique n'est pas adaptée à tout type de substrat. En effet, la technique de dépôt par centrifugation ou de « spin coating » génère des défauts pour les substrats présentant une surface non plane.

Une technique de dépôt a été proposée pour déposer une résine photosensible sur un substrat présentant une face non plane. Cette technique a, par exemple, été reportée par Nga P. Pham et al. dans l'article « Direct spray coating of photoresist-a new method for patterning 3-D structures » (Eurosensors XVI The 16th European Conference on Solid-State Transducers, September 15-18 2002, Prague, Czech Republic). Elle consiste à pulvériser, sur un substrat mis en rotation, un spray d'un composé destiné à former la couche et dilué dans un solvant, à l'aide d'une buse de pulvérisation ultrasonique. Ceci permet de déposer le composé sur l'ensemble du substrat, notamment en déplaçant le substrat par rapport à la buse de pulvérisation. Cette technique est également connue sous le nom anglo-saxon « spray coating ».

K. Fischer et R. Süss ont divulgué dans l'article "Spray Coating - a Solution for resist film deposition accross severe topography" (Electronics Manufacturing Technology Symposium, July 14-16 2004, San Jose, CA, USA) un procédé de dépôt d'une résine photosensible sur un substrat non plan, ledit substrat comportant une partie principale plane et une zone en creux par rapport à la partie principale plane, ledit procédé comportant l'étage du dépôt d'une quantité prédéterminée d'une résine photosensible par pulvérisation d'un spray (spray coating) de ladite résine.

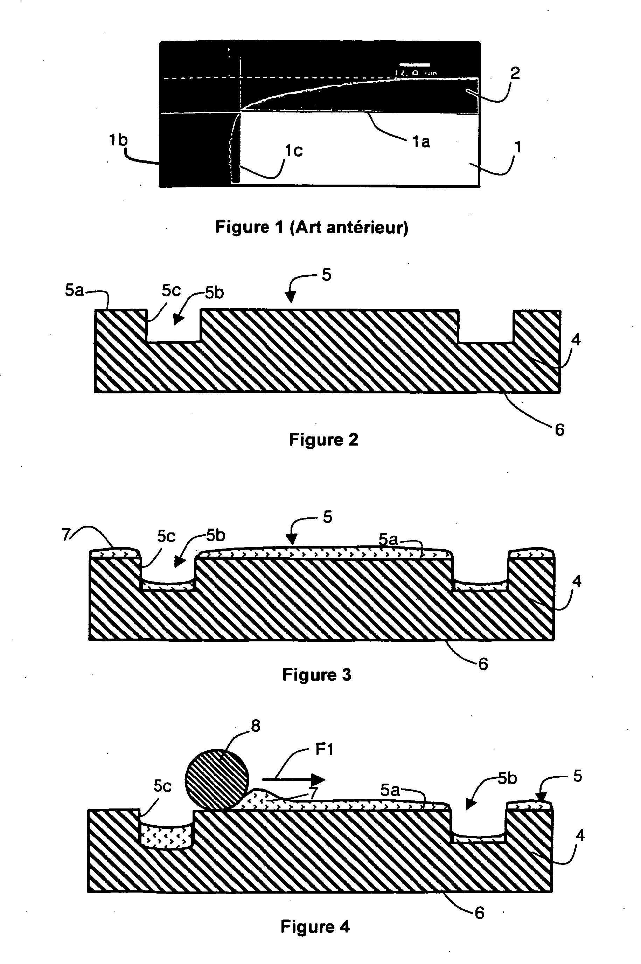

Cette technique reste, cependant, difficile à mettre en oeuvre. De plus, l'épaisseur des couches déposées est limitée car le composé est dilué dans un solvant et il présente une faible viscosité. Ainsi, avec la technique dite de « spray coating », les couches déposées ne peuvent pas avoir une épaisseur supérieure à 10 µm, pour des zones en creux d'une profondeur supérieure à 250µm. De plus, comme représenté sur la figure 1, cette technique n'est pas adaptée aux dépôts sur une face d'un substrat 1, comportant une zone en creux 1b dont la paroi latérale 1 c forme un angle droit avec la partie principale plane 1a de ladite face. En effet, au niveau de l'angle droit également appelé passage de marche, l'épaisseur de la couche déposée 2 est très réduite par rapport à celle déposée sur la partie principale plane 1 a et à celle déposée dans le reste de la zone en creux 1b. La technique de « spray coating » peut même engendrer au niveau dudit passage de marche une absence de produit déposé, créant ainsi une discontinuité de couche déposée. Enfin, cette technique induit une perte de produit importante. En effet, le recouvrement complet du substrat par le composé oblige à vaporiser une grande quantité de solution pour obtenir la quantité réellement nécessaire de composé déposé. Ceci engendre un surcoût financier.

### Objet de l'invention

L'invention a pour but un procédé de dépôt remédiant aux inconvénients de l'art antérieur.

Plus particulièrement, l'invention a pour but un procédé de dépôt permettant de déposer une couche polymère continue sur une face d'un support comportant une partie principale plane et au moins une zone en creux et notamment dans le cas où une paroi latérale de la zone en creux forme un angle droit avec la partie principale plane de la face du support.

Selon l'invention, ce but est atteint par les revendications annexées et, en particulier, par le fait que le procédé comporte au moins les étapes successives suivantes :
- dépôt d'une quantité prédéterminée d'un mélange liquide comprenant au moins le polymère ou au moins un précurseur dudit polymère sur la partie principale plane de la face du support,
- introduction d'au moins une partie du mélange liquide dans la zone en creux par déplacement d'un cylindre posé sur la partie principale plane de la face,
- dépôt d'une quantité supplémentaire de mélange liquide sur la partie principale plane de la face
- et mise en rotation du support selon un axe perpendiculaire au plan de la face.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- La figure 1 représente, en coupe, un support muni d'une zone en creux et recouvert d'une couche déposée selon un procédé de l'art antérieur.
- Les figures 2 à 9 représentent, schématiquement, en coupe, différentes étapes d'un procédé de dépôt selon l'invention.
- La figure 10 représente un cliché obtenu par microscopie électronique à balayage d'une couche polymère déposée par un procédé selon l'invention sur un support muni d'une zone en creux.
- La figure 11 représente, schématiquement, en coupe, une variante de réalisation d'un procédé de dépôt selon l'invention.

### Description de modes particuliers de réalisation

Comme représenté sur les figures 2 à 9, une couche polymère 3 également appelée couche à base de polymère est déposée sur un support 4 selon un mode particulier de réalisation.

Le polymère de la couche 3 peut être un polymère thermoplastique ou thermodurcissable ou un élastomère. Parmi les polymères thermosplastiques, on peut citer le polyimide (PI), le polyamide-imide (PAI), un polymère liquide cristal (LCP), un polysulfone (PSU), le benzo-cyclo-butène (BCB), les colles acryliques, l'éthylène acétate, le polytétrafuoroéthylène (PTFE), le polyfluorure de vinylidène (PVDF), le poly(éthylène téréphtalate) également connu sous le sigle PET. Parmi les polymères thermodurcissables, on peut citer les résines époxy, le silicone, le polyester. La couche polymère 3 peut, de plus, être une couche en résine photosensible, positive ou négative destinée à être utilisée dans une étape de lithographie.

La couche polymère 3 peut également comporter des composants tels que des charges pour modifier certaines propriétés du polymère comme ses propriétés mécaniques et/ou électriques. À titre d'exemple, elle peut comporter des particules de silice, de manière à abaisser le coefficient thermique d'expansion également noté CTE du polymère et à le rapprocher le plus possible de celui du matériau formant le support 4 (par exemple en silicium). Ceci permet de diminuer les contraintes interfaciales liées aux différentes dilatations des matériaux en présence. Selon un autre exemple, la couche polymère 3 peut être rendue conductrice en introduisant dans le polymère des particules chargées, par exemple de cuivre ou de nickel. Une telle couche polymère est, par exemple, réalisée par des techniques de fabrication utilisées dans le domaine des films conducteurs anisotropes.

Le support 4 est, plus particulièrement, un substrat destiné à être utilisé dans le domaine de la microélectronique, par exemple pour former un dispositif microélectronique ou un microsystème. Il est, par exemple, en matériau semi-conducteur tel que du silicium. Sur les figures 2 à 9, il comporte des première et seconde faces opposées 5 et 6, respectivement non plane et plane. La première face 5 comporte une partie principale plane 5a et des zones 5b, en creux par rapport à ladite partie principale plane 5a. Les zones en creux 5b également appelées cavités, peuvent être de tout type de forme. Sur les figures 2 à 9, elles sont de section rectangle et elles comportent une paroi latérale 5c formant un angle droit avec la partie principale plane 5a. L'angle droit est également appelé passage de marche.

La couche polymère 3 est formée sur la première face 5 du support 2, en déposant préalablement, sur la partie principale plane 5a, une quantité prédéterminée d'un mélange liquide 7 contenant le composé à déposer. Ledit composé est, plus particulièrement, le polymère à déposer ou au moins un précurseur dudit polymère, c'est-à-dire un monomère. De plus, le polymère ou le précurseur dudit polymère est, de préférence, dilué dans un solvant et un agent photo-amorceur, tel que la diazo-naphto-quinone (DNQ), peut également être ajouté au mélange. A titre d'exemple, le polymère ou le précurseur dudit polymère peut être dilué dans un solvant tel que le propylène glycol méthyl éther acétate également appelé PGMEA. La viscosité dynamique du mélange liquide 7 est, de préférence, comprise entre environ 10⁻² Pa·s et 1 Pa·s (10⁻² poiseuille noté PI (soit 10 centipoises noté cPo) et 1PI (soit 1000 cPo)).

Plus particulièrement, comme représenté sur la figure 3, le mélange liquide 7 est déposé sur la face 5 du support 4. Il recouvre la partie principale plane 5a et le fond des zones en creux 5b. Il peut, par exemple, être déposé par une étape classique de dépôt par centrifugation (« spin coating »).

Un cylindre ou un rouleau 8 est, ensuite posé sur la partie principale plane 5a du support 4. Il est, alors, déplacé selon un axe parallèle au plan de la partie principale plane 5a du support 4, tout en restant en contact avec ladite partie principale plane 5a. Ce déplacement du cylindre 8 permet de déplacer le mélange liquide 7 présent sur la partie principale plane 5a vers les zones en creux 5b et de l'introduire dans lesdites zones en creux 5b. Sur la figure 4, le déplacement du cylindre 8 est représenté par la flèche F1.

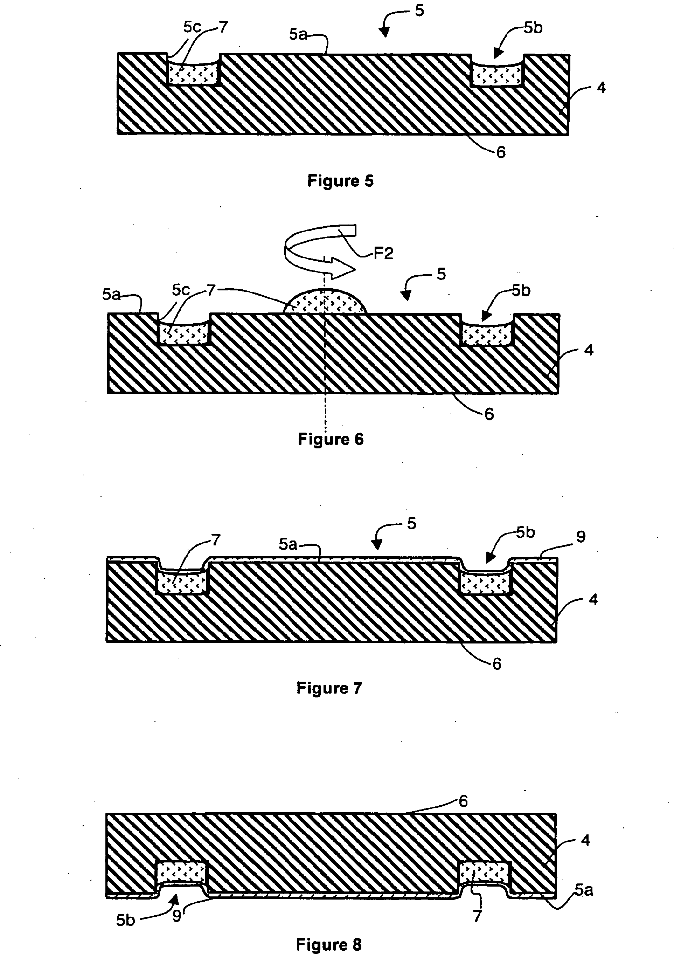

Une fois le cylindre 8 déplacé et comme représenté sur la figure 5, les zones en creux 5b sont au moins partiellement remplies par le mélange liquide 7. Par contre, comme indiqué sur la figure 5, le passage du cylindre 8 sur la partie principale plane 5a peut empêcher que ladite partie principale plane 5a soit recouverte de mélange liquide 7. Dans d'autres cas, la partie principale plante 5a peut être recouverte d'un film de mélange liquide 7 mais l'épaisseur dudit film reste, cependant, très faible du fait du passage du cylindre 8.

Une étape de dépôt par centrifugation (« spin coating «) est alors réalisée, après le passage du cylindre 8, afin de recouvrir de manière satisfaisante la partie principale plane 5a du support, en couche polymère. Comme représenté sur la figure 6, une quantité supplémentaire de mélange liquide 7 est, donc, déposée sur la partie principale 5a du support 4. Puis, le support 4 est mis en rotation. La mise en rotation du support 4 est représentée par la flèche F2 sur la figure 6. La vitesse de rotation du support 4 est déterminée en fonction de l'épaisseur désirée pour la couche polymère.

Le dépôt par centrifugation permet, ainsi, de former un film 9 en mélange liquide 7, sur la première face 5 munie des zones en creux 5b, lesdites zones étant déjà, au moins partiellement remplies de mélange liquide 7. L'ensemble formé par le mélange liquide 7 remplissant au moins partiellement les zones en creux 5b et le film 9 déposé par centrifugation forme alors une couche continue déposée sur la totalité de la première face 5a et présentant une épaisseur suffisante au niveau du passage de marche.

Ladite couche continue est ensuite séchée pour former la couche polymère 3. Ainsi, si le mélange liquide 7 comporte un solvant, celui-ci est éliminé pour obtenir la couche polymère 3. L'élimination du solvant peut être réalisé par tout type de moyen connu, tel que par traitement thermique (recuit) ou par séchage à l'air ambiant. De plus, lorsque le mélange liquide 7 contient un précurseur du polymère, une étape supplémentaire de polymérisation peut être réalisée après l'étape d'élimination du solvant.

Comme illustré sur la figure 8, selon un mode particulier de réalisation, l'étape permettant d'obtenir le polymère à partir du mélange liquide 7 peut être avantageusement réalisée en dirigeant la première face 5 du support 4 vers le bas. Ceci améliore la continuité de la couche polymère 3, notamment au niveau du passage de marche.

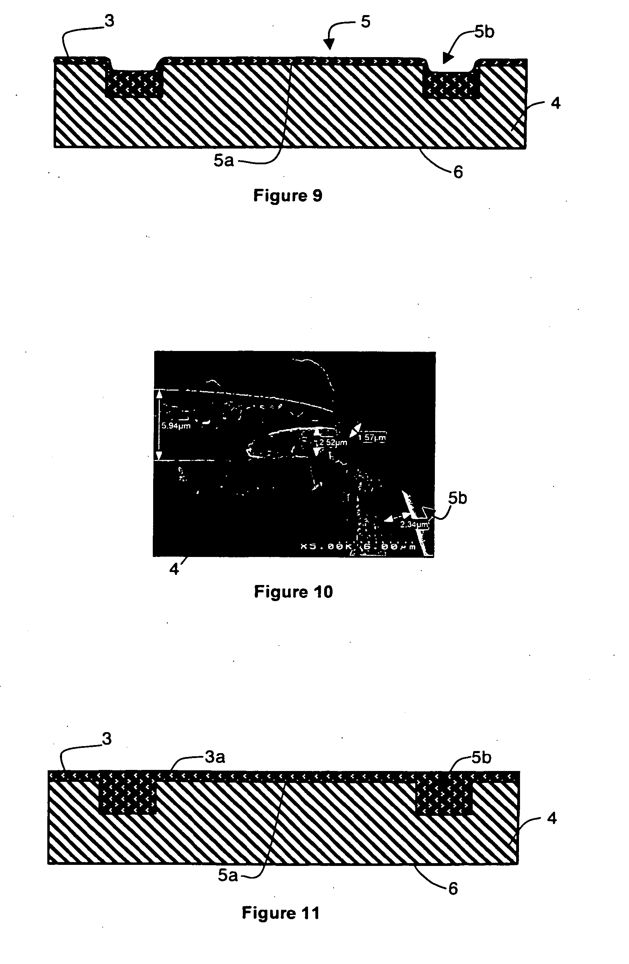

La figure 9 représente la couche polymère 3 déposée sur la première face 5 du support 4, une fois le mélange liquide 7 séché, c'est-à-dire le solvant éliminé et/ou le précurseur polymérisé ou réticulé.

A titre d'exemple, le mélange liquide 7 est une solution commercialisée par la société JSR Corporation sous le nom de PFR IX 335. Une fois la couche continue en mélange liquide 7 déposée, un recuit peut être réalisé à une température de 115°C pendant 90 secondes, puis ladite couche est insolée et un nouveau recuit est réalisé à une température 90°C pendant 90 secondes pour former une couche en résine.

Le procédé de dépôt selon l'invention est simple à mettre en oeuvre. Il permet de réaliser des dépôts de produits visqueux, éventuellement photosensibles, sur des substrats présentant une face non plane avec au moins une zone en creux. Plus particulièrement, la face non plane est totalement recouverte par la couche polymère, même si elle présente une cavité dont la paroi latérale forme, avec la partie plane de la face, un angle droit. À titre d'exemple, la figure 10 représente un cliché obtenu par microscopie à balayage électronique d'un support 4 comportant une face non plane munie d'une cavité 5b et d'une partie principale plane 5a. Ladite face 5 est recouverte par une couche en BCB, en mettant en oeuvre un procédé tel que celui représenté sur les figures 2 à 9. La cavité 5b a une profondeur de 70µm et une largeur de 80 µm et sa paroi latérale 5c forme un angle droit avec la partie principale plane 5a. On constate sur la figure 9 que la couche en BCB ne présente aucune discontinuité sur la totalité de la face non plane, même au niveau de l'angle droit. Ainsi, sur la partie principale plane 5a, la couche en BCB présente une épaisseur de 5,94µm et, au niveau de l'angle droit, son épaisseur totale est de 4,09 µm. De plus, dans la cavité 5b, la couche en BCB est formée de deux sous-couches, formées respectivement par application du cylindre 8 et par centrifugation tandis que sur la partie principale plane, elle n'est quasiment formée que de la sous-couche déposée par centrifugation.

Enfin, dans une variante de réalisation représentée sur la figure 11, les zones en creux peuvent être totalement remplies de mélange liquide de manière à obtenir une couche polymère 3 présentant une face libre 3a plane.

## Revendications

1. Procédé de dépôt d'une couche polymère (3) sur une face (5) d'un support (4), ladite face (5) comportant une partie principale plane (5a) et au moins une zone en creux (5b) par rapport à la partie principale plane (5a), **caractérisé en ce qu'**il comporte au moins les étapes successives suivantes :
- dépôt d'une quantité prédéterminée d'un mélange liquide (7) comprenant au moins le polymère ou au moins un précurseur dudit polymère sur la partie principale plane (5a) de la face (5) du support (4),
- introduction d'au moins une partie du mélange liquide (7) dans la zone en creux (5b) par déplacement d'un cylindre (8) posé sur la partie principale plane (5a) de la face (5)
- dépôt d'une quantité supplémentaire de mélange liquide (7) sur la partie principale plane (5a) de la face (5)
- et mise en rotation du support (4) selon un axe perpendiculaire au plan de la face (5).

2. Procédé selon la revendication 1, **caractérisé en ce que** le mélange liquide (7) comporte un solvant dans lequel est dilué le polymère ou le précurseur de polymère.

3. Procédé selon la revendication 2, **caractérisé en ce que** le solvant est éliminé après la mise en rotation du support (4).

4. Procédé selon la revendication 3 **caractérisé en ce que** l'élimination du solvant est réalisée par une étape de recuit.

5. Procédé selon l'une des revendications 3 et 4, **caractérisé en ce que** la face (5) du support (4) est dirigée vers le bas pendant l'élimination du solvant.

6. Procédé selon l'une quelconque des revendications 1 à 5, **caractérisé en ce que** la couche polymère (3) est une couche polymère photosensible.

7. Procédé selon l'une quelconque des revendications 1 à 6, **caractérisé en ce que** le mélange liquide (7) présente une viscosité dynamique comprise entre 10⁻² Pa·s et 1 Pa·s (10⁻² PI et 1 PI)

8. Procédé selon l'une quelconque des revendications 1 à 7, **caractérisé en ce que** la zone en creux (5b) est totalement remplie de mélange liquide (7) pendant l'étape d'introduction.

9. Procédé selon l'une quelconque des revendications 1 à 8, **caractérisé en ce que** la zone en creux (5b) présente une paroi latérale (5c) formant un angle droit avec la partie principale plane (5a).

## Claims

1. A method for depositing a polymer layer (3) on a surface (5) of a support (4), said surface (5) comprising a flat main part (5a) and at least a recessed zone (5b) with respect to the flat main part (5a), **characterized in that** it comprises at least the following successive steps:
- deposition of a predetermined quantity of a liquid mixture (7) comprising at least the polymer or at least a precursor of said polymer on the flat main part (5a) of the surface (5) of the support (4),
- introducing at least a part of the liquid mixture (7) into the recessed zone (5b) by moving a cylinder (8) placed on the flat main part (5a) of the surface (5),
- deposition of an additional quantity of liquid mixture (7) on the flat main part (5a) of the surface (5),
- and rotation of the support (4) along an axis perpendicular to the plane of the surface (5).

2. The method according to claim 1, **characterized in that** the liquid mixture (7) comprises a solvent in which the polymer or polymer precursor is diluted.

3. The method according to claim 2, **characterized in that** the solvent is eliminated after the support (4) has been rotated.

4. The method according to claim 3, **characterized in that** elimination of the solvent is achieved by performing an annealing step.

5. The method according to one of claims 3 and 4, **characterized in that** the surface (5) of the support (4) is directed downwards during elimination of the solvent.

6. The method according to any one of claims 1 to 5, **characterized in that** the polymer layer (3) is a photosensitive polymer layer.

7. The method according to any one of claims 1 to 6, **characterized in that** the liquid mixture (7) presents a dynamic viscosity comprised between 10⁻² Pa.s and 1 Pa.s (10⁻² PI and 1 PI).

8. The method according to any one of claims 1 to 7, **characterized in that** the recessed zone (5b) is totally filled with liquid mixture (7) during the introduction step.

9. The method according to any one of claims 1 to 8, **characterized in that** the recessed zone (5b) presents a side wall (5c) forming a right angle with the flat main part (5a).

## Patentansprüche

1. Verfahren zum Abscheiden einer Polymerschicht (3) auf einer Seite (5) eines Trägers (4), wobei die Seite (5) einen ebenen Hauptteil (5a) und wenigstens einen gegenüber dem ebenen Hauptteil (5a) vertieften Bereich (5b) aufweist, **dadurch gekennzeichnet, dass** es wenigstens die folgenden aufeinander folgenden Schritte umfasst:
- Abscheiden einer vorbestimmten Menge eines flüssigen Gemischs (7), das wenigstens das Polymer oder wenigstens einen Vorläufer des Polymers umfasst, auf dem ebenen Hauptteil (5a) der Seite (5) des Trägers (4),
- Einbringen wenigstens eines Teils des flüssigen Gemischs (7) in den vertieften Bereich (5b) durch Bewegen eines auf den ebenen Hauptteil (5a) der Seite (5) aufgesetzten Zylinders (8),
- Abscheiden einer zusätzlichen Menge an flüssigem Gemisch (7) auf dem ebenen Hauptteil (5a) der Seite (5) und
- Indrehungversetzen des Trägers (4) um eine zu der Ebene der Seite (5) senkrechte Achse.

2. Verfahren nach Anspruch 1, **dadurch gekennzeichnet, dass** das flüssige Gemisch (7) ein Lösungsmittel umfasst, in dem das Polymer oder der Polymervorläufer verdünnt ist.

3. Verfahren nach Anspruch 2, **dadurch gekennzeichnet, dass** das Lösungsmittel nach dem Indrehungversetzen des Trägers (4) entfernt wird.

4. Verfahren nach Anspruch 3, **dadurch gekennzeichnet, dass** das Entfernen des Lösungsmittels durch einen Glühschritt vollzogen wird.

5. Verfahren nach einem der Ansprüche 3 und 4, **dadurch gekennzeichnet, dass** die Seite (5) des Trägers (4) während des Entfernens des Lösungsmittels nach unten gewandt ist.

6. Verfahren nach einem der Ansprüche 1 bis 5, **dadurch gekennzeichnet, dass** die Polymerschicht (3) eine lichtempfindliche Polymerschicht ist.

7. Verfahren nach einem der Ansprüche 1 bis 6, **dadurch gekennzeichnet, dass** das flüssige Gemisch (7) eine dynamische Viskosität im Bereich zwischen 10⁻² Pa•s und 1 Pa•s (10⁻² PI und 1 PI) aufweist.

8. Verfahren nach einem der Ansprüche 1 bis 7, **dadurch gekennzeichnet, dass** der vertiefte Bereich (5b) während des Einbringschrittes vollständig mit flüssigem Gemisch (7) gefüllt wird.

9. Verfahren nach einem der Ansprüche 1 bis 8, **dadurch gekennzeichnet, dass** der vertiefte Bereich (5b) eine Seitenwand (5c) aufweist, die mit dem ebenen Hauptteil (5a) einen rechten Winkel bildet.
